# EUROPEAN PATENT APPLICATION

(11) **EP 4 597 551 A1**
(43) Date of publication of application: **06.08.2025**
(21) Application number: 24200459.6
(22) Date of filing: 16.09.2024
(51) Int. Cl.: H01L 21/56, H01L 23/31, H01L 23/498, H01L 25/07

(54) **SEMICONDUCTOR MODULE AND MANUFACTURING METHOD THEREOF**

(30) Priority: 30.01.2024 TW 113103534
(71) Applicant: Actron Technology Corporation, Taoyuan City 338 (TW)
(72) Inventor: TSAI, Hsin-Chang, 338 Taoyuan City (TW); LIU, Ching-Wen, 338 Taoyuan City (TW)
(74) Representative: Becker, Eberhard

(57) **Abstract**

A semiconductor module (100) includes a substrate (110), at least one chip (120), at least one signal assembly (130) and an encapsulant (140). The chip (120) and the signal assembly (130) are disposed on and electrically connected to the substrate (110). The signal assembly (130) includes at least one power semiconductor package signal connection element (132) disposed on the substrate (110) and at least one implanted signal pin (134) inserted into the power semiconductor package signal connection element (132). The encapsulant (140) has at least one groove (142). The encapsulant (140) covers the chip (120) and the power semiconductor package signal connection element (132). From a top surface (141) of the encapsulant (140) relatively away from the substrate (110), the groove (142) extends toward the substrate (110) until at least an upper surface (133) of the power semiconductor package signal connection element (132) is exposed.

## Description

### BACKGROUND

### Technical Field

The disclosure relates to a module and a manufacturing method thereof, and in particular to a semiconductor module and a manufacturing method thereof.

### Description of Related Art

To increase the power density of power elements and meet low-cost requirements, multiple semiconductor elements are generally combined in a package structure to form a power module, thereby providing high output power with a small-volume package structure. Generally, signal sources of the power module all protrude to outside from the lateral surface of the encapsulant. However, in this design, longer current paths lead to an increase in parasitic inductance, thereby affecting the performance of the elements. Moreover, during the formation of the encapsulant using existing technologies, the power semiconductor package signal connection element is usually protected from the injected encapsulant by a secondary injection or a one-time injection without grinding or covering protection materials. Also, a secondary processing such as mechanical or laser drilling may be further performed to expose the upper surface of the power semiconductor package signal connection element. As a result, the manufacturing time and cost of power modules cannot be effectively reduced.

### SUMMARY

The disclosure provides a semiconductor module to effectively shorten the current path and further reduce parasitic inductance.

The disclosure also provides a manufacturing method of a semiconductor module to manufacture the aforementioned semiconductor module and reduce the complexity of the manufacturing process as well as the risk of damaging the power module due to the need for second processing. This increases the yield and effectively reduces the manufacturing cost and time.

A semiconductor module of the disclosure includes a substrate, at least one chip, at least one signal assembly, and an encapsulant. The at least one chip is disposed on and electrically connected to the substrate. The at least one signal assembly is disposed on the substrate along a normal direction of the substrate and electrically connected to the substrate. The at least one signal assembly includes at least one power semiconductor package signal connection element that is disposed on the substrate, and at least one implanted signal pin that is inserted into the at least one power semiconductor package signal connection element. The encapsulant is disposed on the substrate and has at least one groove. The encapsulant covers the at least one chip and the at least one power semiconductor package signal connection element. From a top surface of the encapsulant relatively away from the substrate, the at least one groove extends towards the substrate until at least one upper surface of the at least one power semiconductor package signal connection element is exposed.

In an embodiment of the disclosure, a diameter of the at least one groove tapers from the top surface of the encapsulant towards the substrate.

In an embodiment of the disclosure, a height of the at least one power semiconductor package signal connection element is greater than a depth of the at least one groove.

In an embodiment of the disclosure, the semiconductor module further includes at least one connector that electrically connects between the at least one chip and the substrate.

A manufacturing method of a semiconductor module of the disclosure includes steps below. At least one chip is disposed on a substrate. The at least one chip is electrically connected to the substrate. At least one power semiconductor package signal connection element is disposed on the substrate along a normal direction of the substrate. The at least one power semiconductor package signal connection element is electrically connected to the substrate. The substrate and the at least one chip and the at least one power semiconductor package signal connection element disposed on the substrate are positioned in a lower mold. An upper mold and the lower mold are closed to form an encapsulation cavity. At least one retractable mold block of the upper mold is abutted on at least one upper surface of the at least one power semiconductor package signal connection element. An encapsulant is injected into the encapsulation cavity. The encapsulant is disposed on the substrate and covers the at least one chip and the at least one power semiconductor package signal connection element. The upper mold and the lower mold are removed to form at least one groove in the encapsulant, the at least one groove extending from a top surface of the encapsulant relatively away from the substrate towards the substrate until the at least one upper surface of the at least one power semiconductor package signal connection element is exposed. At least one implanted signal pin is inserted into the at least one power semiconductor package signal connection element through the at least one groove. The at least one power semiconductor package signal connection element and the at least one implanted signal pin define at least one signal assembly.

In an embodiment of the disclosure, a diameter of the at least one groove tapers from the top surface of the encapsulant towards the substrate.

In an embodiment of the disclosure, a height of the at least one power semiconductor package signal connection element is greater than a depth of the at least one groove.

In an embodiment of the disclosure, the manufacturing method of a semiconductor module further includes forming at least one connector before the upper mold and the lower mold are closed to form the encapsulation cavity, and the at least one connector electrically connects between the at least one chip and the substrate.

In an embodiment of the disclosure, the substrate has a first surface and a second surface opposite to each other. The substrate also includes a plurality of pins. With the encapsulant injected into the encapsulation cavity, the encapsulant covers the first surface of the substrate and a portion of each pin, the portion of each pin being defined as an inner pin portion of each pin. Another portion of each pin protruding outside the encapsulant is defined as an outer pin portion of each pin.

In an embodiment of the disclosure, the substrate includes a direct bonded copper substrate, an insulated metal substrate, or an active metal bonding substrate.

Based on the above, in the manufacturing method of a semiconductor module of the disclosure, the retractable mold blocks of the upper mold abut on the upper surfaces of the power semiconductor package signal connection elements, which are disposed along the normal direction of the substrate and electrically connected to the substrate. In addition, the encapsulant is formed integrally by one-time injection into the encapsulation cavity of the closed molds. As a result, after demolding, the encapsulant is formed with the grooves exposing the upper surfaces of the power semiconductor package signal connection elements. Compared to existing technologies, the manufacturing method of a semiconductor module of the disclosure does not require additional processing procedures to expose the upper surfaces of the power semiconductor package signal connection elements from the encapsulant, which leads to the reduction of manufacturing cost and time. Moreover, since the implanted signal pins are inserted into the power semiconductor package signal connection elements through the grooves of the encapsulant, the current path between the substrate and the signal assembly may be effectively shortened to reduce parasitic inductance.

To make the aforementioned features and advantages of the disclosure more apparent and comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.

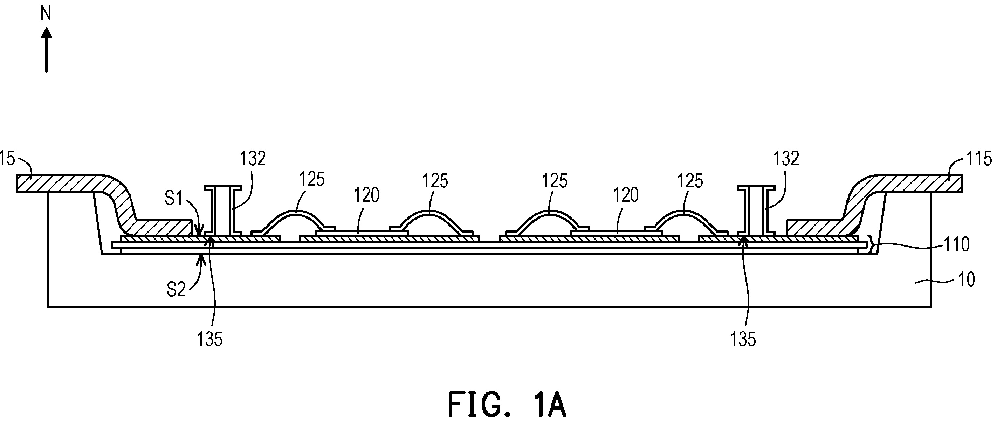

FIG. 1A to FIG. 1E are schematic cross-sectional diagrams showing a manufacturing method of a semiconductor module according to an embodiment of the disclosure.

### DESCRIPTION OF THE EMBODIMENTS

The embodiments of the disclosure can be understood together with the drawings, and the drawings of the disclosure are also regarded as part of the description of the disclosure. It is understood that the drawings of the disclosure are not drawn to scale. In fact, the size of an element may be arbitrarily exaggerated or reduced to clearly illustrate the features of the disclosure.

FIG. 1A to FIG. 1E are schematic cross-sectional diagrams showing a manufacturing method of a semiconductor module according to an embodiment of the disclosure. In the manufacturing method of a semiconductor module in this embodiment, referring to FIG. 1A first, a substrate 110 is provided. The substrate 110 is, for example, a direct bonded copper (DBC) substrate, an insulated metal substrate (IMS), or an active metal bonding (AMB) substrate, but is not limited thereto. In this embodiment, the substrate 110 has a first surface S1 and a second surface S2 that are opposite to each other. The substrate 110 further includes a plurality of pins 115 (with two pins 115 shown schematically in the drawings), which are respectively disposed on the first surface S1 of the substrate 110.

Next, referring to FIG. 1A again, at least one chip (with two chips 120 shown schematically in the drawings) is disposed on the substrate 110. The chips 120 are disposed apart from each other on the first surface S1 of the substrate 110 and are located between the pins 115. The chips 120 may be, for example, insulated gate bipolar transistors (IGBTs) or silicon carbide metal-oxide-semiconductor field-effect transistor diodes (SiC MOSFET diodes), but are not limited thereto.

Next, referring to FIG. 1A again, at least one connector 125 is formed (with four connectors 125 shown schematically in the drawings), and the connector 125 electrically connects between the chip 120 and the substrate 110. That is, the chips 120 are electrically connected to the substrate 110 through the connectors 125. The connector 125 may be, for example, a bonding wire or a metal clip, but is not limited thereto.

Next, referring to FIG. 1A again, at least one power semiconductor package signal connection element (with two power semiconductor package signal connection elements 132 shown schematically in the drawings) is disposed on the substrate 110 along a normal direction N of the substrate 110. Lower surfaces 135 of the power semiconductor package signal connection elements 132 are in direct contact with the first surface S1 of the substrate 110, and the power semiconductor package signal connection elements 132 are electrically connected to the substrate 110. In other words, the power semiconductor package signal connection elements 132 and the chips 120 are located on the same surface of the substrate 110, and the power semiconductor package signal connection element 132 is located between a chip 120 and a pin 115. The power semiconductor package signal connection elements 132 may be fixed on the substrate 110 by, for example, soldering.

Next, referring to FIG. 1A again, the substrate 110, the chips 120 disposed on the substrate 110, and the power semiconductor package signal connection elements 132 disposed on the substrate 110 are positioned inside a lower mold 10.

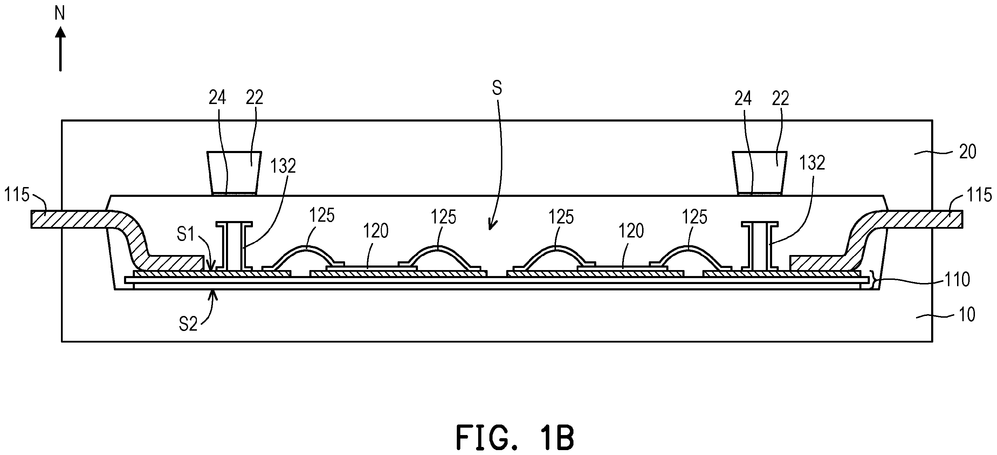

Then, referring to FIG. 1B, an upper mold 20 and the lower mold 10 are closed together, forming an encapsulation cavity S. At this time, the upper mold 20 has at least one retractable mold block (with two retractable mold blocks 22 shown schematically in the drawings). The retractable mold blocks 22 are able to extend out from the inside of the upper mold 20 to outside of the upper mold 20, and are also able to retract back from outside of the upper mold 20 into the upper mold 20. In a cross-sectional view, the cross-sectional shape of each retractable mold block 22 may be, for example, an inverted trapezoid. The angle of inclination of the retractable mold blocks 22 may be deemed a draft angle. Herein, for the convenience of subsequent demolding, a release layer 24 may also be disposed at the bottom of the retractable mold block 22. In an embodiment, the material of the release layer 24 is, for example, Teflon but is not limited thereto.

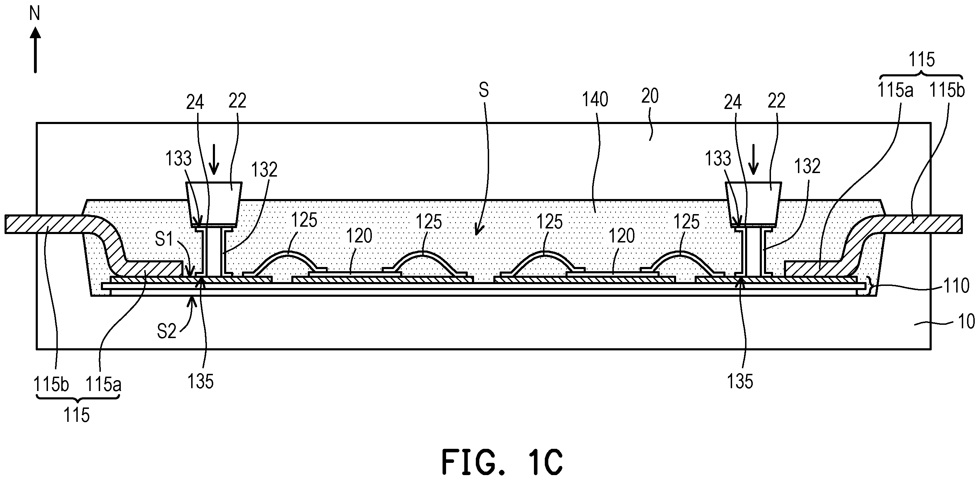

Next, referring to both FIG. 1B and FIG. 1C, the retractable mold block 22 of the upper mold 20 extends out from the inside of the upper mold 20 to abut on an upper surface 133 of the power semiconductor package signal connection element 132. In other words, the retractable mold block 22 is able to abut on and cover the upper surface 133 of the power semiconductor package signal connection element 132, and the release layer 24 is located between the retractable mold block 22 and the upper surface 133 of the power semiconductor package signal connection element 132.

Next, referring to FIG. 1C again, an encapsulant 140 is injected into the encapsulation cavity S, and the encapsulant 140 is disposed on the substrate 110 and covers the chips 120 and the power semiconductor package signal connection elements 132. As shown in FIG. 1C, the encapsulant 140 covers a portion of the first surface S1 of the substrate 110, the chips 120, the connectors 125, the power semiconductor package signal connection elements 132, and a portion of each pin 115. The portion of each pin 115 covered by the encapsulant 140 may be defined as an inner pin portion 115a of each pin 115, and another portion of each pin 115 protruding outside the encapsulant 140 may be defined as an outer pin portion 115b of each pin 115. The material of the encapsulant 140 may be, for example, an epoxy molding compound (EMC), but is not limited thereto.

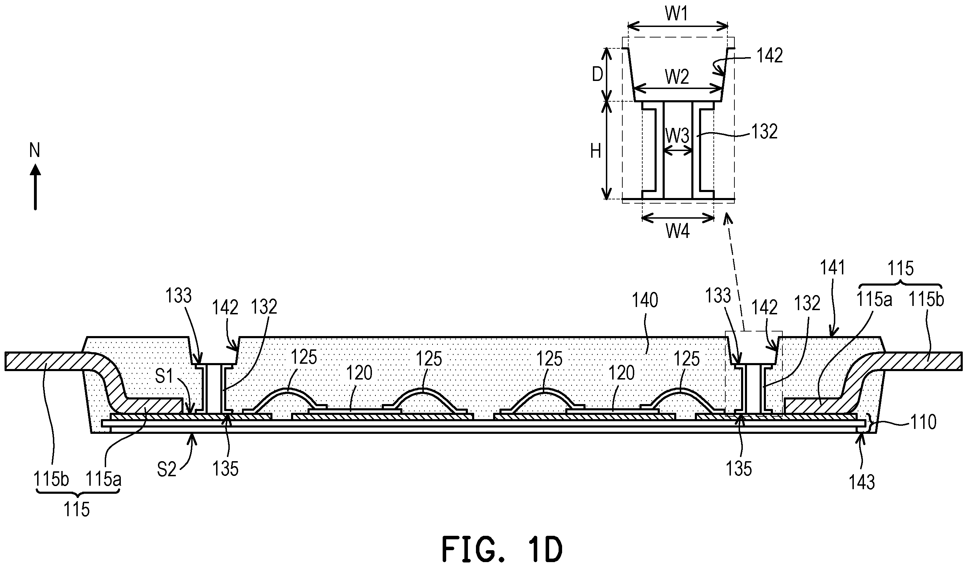

Subsequently, referring to both FIG. 1C and FIG. 1D, the upper mold 20 and the lower mold 10 are removed, thereby forming at least one groove (with two grooves 142 shown schematically in the drawings) in the encapsulant 140. From a top surface 141 of the encapsulant 140 relatively away from the substrate 110, the groove 142 extends towards the substrate 110 until the upper surface 133 of the power semiconductor package signal connection element 132 is exposed. That is, the grooves 142 are defined by the retractable mold blocks 22 of the upper mold 20. When the upper mold 20 is removed, the structure of the groove 142 is formed. In an embodiment, the diameter of the groove 142 tapers from the top surface 141 of the encapsulant 140 towards the substrate 110, meaning that an upper diameter W1 of the groove 142 is greater than a lower diameter W2. In an embodiment, in a cross-sectional view, the shape of the groove 142 may be, for example, an inverted trapezoid, but is not limited thereto. In this exemplary embodiment, the lower diameter W2 of the groove 142 is greater than an inner diameter W3 of the power semiconductor package signal connection element 132. In an embodiment, the lower diameter W2 of the groove 142 is greater than an outer diameter W4 of the power semiconductor package signal connection element 132. As shown in FIG. 1D, a height H of the power semiconductor package signal connection element 132 is greater than a depth D of the groove 142. Additionally, in this embodiment, a bottom surface 143 of the encapsulant 140 may be flush with the second surface S2 of the substrate 110.

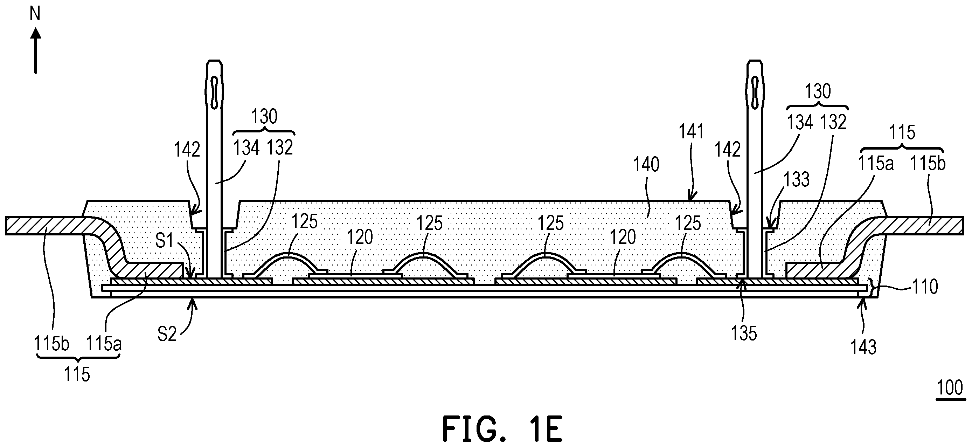

Finally, referring to FIG. 1E, at least one implanted signal pin (with two implanted signal pins 134 shown schematically in the drawings) is inserted through the groove 142 into the power semiconductor package signal connection element 132, thereby electrically connecting a signal assembly 130 to the substrate 110. Herein, one power semiconductor package signal connection element 132 and one implanted signal pin 134 may define one signal assembly 130. As shown in FIG. 1E, the implanted signal pins 134 in this embodiment are not in direct contact with the encapsulant 140. Furthermore, since the implanted signal pins 134 are specifically vertical signal terminals directly inserted to (or contacting) the first surface S1 of the substrate 110, a current path between the substrate 110 and the signal assembly 130 is effectively shortened, leading to the reduction of parasitic inductance. So far, the manufacturing of a semiconductor module 100 is completed.

In this embodiment, the retractable mold blocks 22 of the upper mold 20 abut on the upper surfaces 133 of the power semiconductor package signal connection elements 132, which are disposed along the normal direction N of the substrate 110 and electrically connected to the substrate 110. In addition, the encapsulant 140 is formed integrally by one-time injection into the encapsulation cavity S of the closed molds. As a result, after demolding, the encapsulant 140 is formed with the grooves 142 exposing the upper surfaces 133 of the power semiconductor package signal connection elements 132. Compared to existing technologies, the manufacturing method of the semiconductor module 100 in this embodiment does not require additional processing procedures to expose the upper surfaces 133 of the power semiconductor package signal connection elements 132 from the encapsulant 140, which leads to the reduction of manufacturing cost and time. Moreover, since the implanted signal pins 134 may be inserted into the power semiconductor package signal connection elements 132 through the grooves 142, the current path between the substrate 110 and the signal assembly 130 can be effectively shortened to reduce parasitic inductance. Further, since the implanted signal pins 134 are inserted into the power semiconductor package signal connection elements 132 with direct contact to the substrate 110, solder is not required for connection, and the cost is thus effectively reduced.

In terms of structure, referring to FIG. 1E again, in this embodiment, the semiconductor module 100 includes a substrate 110, chips 120, signal assemblies 130, and an encapsulant 140. The chips 120 are disposed on and electrically connected to the substrate 110. The signal assemblies 130 are electrically connected to the substrate 110 and disposed on the substrate 110 along a normal direction N of the substrate 110. The signal assembly 130 includes a power semiconductor package signal connection element 132 disposed on the substrate 110, and an implanted signal pin 134 inserted into the power semiconductor package signal connection element 132. The encapsulant 140 is disposed on the substrate 110 and has grooves 142. The encapsulant 140 covers the chips 120 and the power semiconductor package signal connection elements 132. From a top surface 141 of the encapsulant 140 relatively away from the substrate 110, the grooves 142 extend towards the substrate 110 until upper surfaces 133 of the power semiconductor package signal connection elements 132 are exposed.

Further, in this embodiment, the substrate 110 has a first surface S1 and a second surface S2 that are opposite to each other. The substrate 110 further includes a plurality of pins 115. Each pin 115 includes an inner pin portion 115a and an outer pin portion 115b. The encapsulant 140 covers the first surface S1 of the substrate 110, the power semiconductor package signal connection elements 132, and the inner pin portion 115a of each pin 115, while the outer pin portion 115b of each pin 115 protrudes outside the encapsulant 140. That is, the implanted signal pins 134 in this embodiment are not in direct contact with the encapsulant 140. Furthermore, the semiconductor module 100 further includes connectors 125, which electrically connect between the chips 120 and the substrate 110. In addition, the diameter of the grooves 142 tapers from a top surface 141 of the encapsulant 140 towards the substrate 110, exposing the upper surfaces 133 of the power semiconductor package signal connection elements 132.

In summary, in the manufacturing method of a semiconductor module of the disclosure, the retractable mold blocks of the upper mold abut on the upper surfaces of the power semiconductor package signal connection elements, which are disposed along the normal direction of the substrate and electrically connected to the substrate. In addition, the encapsulant is formed integrally by one-time injection into the encapsulation cavity of the closed molds. As a result, after demolding, the encapsulant is formed with the grooves exposing the upper surfaces of the power semiconductor package signal connection elements. Compared to existing technologies, the manufacturing method of a semiconductor module of the disclosure does not require additional processing procedures to expose the upper surfaces of the power semiconductor package signal connection elements from the encapsulant, which leads to the reduction of manufacturing cost and time. Moreover, since the implanted signal pins may be inserted into the power semiconductor package signal connection elements through the grooves of the encapsulant, the current path between the substrate and the signal assembly can be effectively shortened to reduce parasitic inductance.

## Claims

1. A semiconductor module (100), comprising:
a substrate (110);
at least one chip (120) disposed on and electrically connected to the substrate (110);
at least one signal assembly (130) disposed on the substrate (110) along a normal direction (N) of the substrate (110) and electrically connected to the substrate (110), the at least one signal assembly (130) comprising at least one power semiconductor package signal connection element (132) disposed on the substrate (110) and at least one implanted signal pin (134) inserted into the at least one power semiconductor package signal connection element (132); and
an encapsulant (140) disposed on the substrate (110), having at least one groove (142), and covering the at least one chip (120) and the at least one power semiconductor package signal connection element (132), wherein the at least one groove (142) extends from a top surface (141) of the encapsulant (140) relatively away from the substrate (110) towards the substrate (110) until at least one upper surface (133) of the at least one power semiconductor package signal connection element (132) is exposed.

2. The semiconductor module (100) of claim 1, wherein a diameter of the at least one groove (142) tapers from the top surface (141) of the encapsulant (140) towards the substrate (110).

3. The semiconductor module (100) of claim 1, wherein a height (H) of the at least one power semiconductor package signal connection element (132) is greater than a depth (D) of the at least one groove (142).

4. The semiconductor module (100) of claim 1, further comprising:
at least one connector (125) electrically connecting between the at least one chip (120) and the substrate (110).

5. A manufacturing method of a semiconductor module (100), comprising:
disposing at least one chip (120) on a substrate (110), the at least one chip (120) being electrically connected to the substrate (110);
disposing at least one power semiconductor package signal connection element (132) on the substrate (110) along a normal direction (N) of the substrate (110), the at least one power semiconductor package signal connection element (132) being electrically connected to the substrate (110);
positioning the substrate (110) and the at least one chip (120) and the at least one power semiconductor package signal connection element (132) disposed on the substrate (110) in a lower mold (10);
closing an upper mold (20) and the lower mold (10) to form an encapsulation cavity (S), wherein at least one retractable mold block (22) of the upper mold (20) abuts on at least one upper surface (133) of the at least one power semiconductor package signal connection element (132);
injecting an encapsulant (140) into the encapsulation cavity (S), wherein the encapsulant (140) is disposed on the substrate (110) and covers the at least one chip (120) and the at least one power semiconductor package signal connection element (132);
removing the upper mold (20) and the lower mold (10) to form at least one groove (142) in the encapsulant (140), the at least one groove (142) extending from a top surface (141) of the encapsulant (140) relatively away from the substrate (110) towards the substrate (110) until the at least one upper surface (133) of the at least one power semiconductor package signal connection element (132) is exposed; and
inserting at least one implanted signal pin (134) into the at least one power semiconductor package signal connection element (132) through the at least one groove (142), wherein the at least one power semiconductor package signal connection element (132) and the at least one implanted signal pin (134) define at least one signal assembly (130).

6. The manufacturing method of the semiconductor module (100) of claim 5, wherein a diameter of the at least one groove (142) tapers from the top surface (141) of the encapsulant (140) towards the substrate (110).

7. The manufacturing method of the semiconductor module (100) of claim 5, wherein a height (H) of the at least one power semiconductor package signal connection element (132) is greater than a depth (D) of the at least one groove (142).

8. The manufacturing method of the semiconductor module (100) of claim 5, further comprising:
forming at least one connector (125) before closing the upper mold (20) and the lower mold (10) to form the encapsulation cavity (S), the at least one connector (125) electrically connecting between the at least one chip (120) and the substrate (110).

9. The manufacturing method of the semiconductor module (100) of claim 5, wherein the substrate (110) has a first surface (S1) and a second surface (S2) opposite to each other, and comprises a plurality of pins (115), and
with the encapsulant (140) injected into the encapsulation cavity (S), the encapsulant (140) covers the first surface (S1) of the substrate (110) and a portion of each of the pins (115), the portion of each of the pins (115) being defined as an inner pin portion (115a) of each of the pins (115), and another portion of each of the pins (115) protrudes outside the encapsulant (140), the another portion of each of the pins (115) being defined as an outer pin portion (115b) of each of the pins (115).

10. The manufacturing method of the semiconductor module (100) of claim 5, wherein the substrate (110) comprises a direct bonded copper substrate, an insulated metal substrate, or an active metal bonding substrate.
